# EUROPEAN PATENT SPECIFICATION

(11) **EP 0 470 677 B1**
(45) Date of publication and mention of the grant of the patent: **07.12.1994**
(21) Application number: 91250191.3
(22) Date of filing: 15.07.1991
(51) Int. Cl.: C30B 13/24, H01J 65/04

(54) **An image heating apparatus using a microwave discharge plasma lamp**
Vorrichtung zum Erhitzen einer Zone unter Verwendung einer Mikrowellen-Plasmaentladungslampe
Appareil pour chauffer une image utilisant une lampe à décharge de plasma par micro-ondes

(30) Priority: 08.08.1990 JP 210032/90; 30.11.1990 JP 335279/90
(43) Date of publication of application: 12.02.1992
(73) Proprietor: MITSUBISHI DENKI KABUSHIKI KAISHA, Tokyo (JP)
(72) Inventor: Abe, Toshio, c/o Kamakura Seisakusho, Kamakura-shi, Kanagawa-ken (JP)
(74) Representative: Pfenning, Meinig & Partner

(56) References cited:
- EP-A- 0 438 179
- JP-A-02 180 784
- PATENT ABSTRACTS OF JAPAN, unexamined applications, M field, vol. 14, no. 247, May 25, 1990, THE PATENT OFFICE JAPANESE GOVERNMENT, p. 116 M 978; & JP-A-02 68 486

## Description

The present invention relates to an image heating apparatus according to the pre-characterising part of claim 1.

JP-A-2-68 486 discloses an image heating device comprising a plasma lamp placed at the first focus of an oval mirror and a circular screening plate of wire mesh for screening waves placed in the end position of the oval mirror adjacent the plasma lamp. The periphery of the screening plate is in contact with the inside of the oval mirror to form a cavity resonator. Light emitted from the plasma lamp permeates through the screening plate and is focused by the mirror to heat a work piece located at the second focus. The plasma lamp has a diameter of 10 to 30 mm; therefore, the image focused on the work piece is sufficiently large to give light of a uniform intensity over the work piece, so that the temperature of the work piece can be raised uniformly.

In the prior European patent application number 91 100 609.6 (publication no. 0 438 179), which is prior art according to the provisions of Art. 54(3)EPC, an image heating apparatus using a plasma lamp is disclosed. This apparatus comprises at least one rotary elliptical mirror having a reflection surface of an elliptical body at the inside, a plasma lamp disposed at the first focal point of the mirror, a cavity resonator defined by the mirror and an electric wave shielding member provided inside the rotary elliptical mirror and accomodating the plasma lamp, a high frequency oscillator for supplying electromagnetic wave to the cavity resonator via a wave guide, and a test sample disposed at the second focal point of the rotary elliptical mirror. The electric wave shielding member can have the form of a plate with the peripheral edge thereof in contact with the inner surface of the rotary elliptical mirror, or it can have a cup-like configuration with the peripheral edge thereof at the open side in contact with the inner surface of the rotary elliptical mirror. The plasma lamp can have a cylindrical or a disc-like form.

It is an object of the present invention to provide an image heating apparatus as disclosed in EP 0 438 179 A1 which is capable of expanding or reducing the heating area. For solving this object, according to the invention the plasma lamp means is rotatable of the end of the elliptical mirror.

In case an image heating apparatus with a cylindrical type microwave discharge lamp as the light source is used, rotating of the lamp can dispose it in parallel with the test sample when it is necessary to expand the heating area and also dispose it so as to be normal to the test sample when it is necessary to reduce the heating area.

In case an image heating apparatus with a disc type plasma lamp as the light source is used, rotating of the lamp can dispose it in parallel with a test sample when it is necessary to expand the heating area and also dispose it to be normal to the test sample when it is necessary to reduce the heating area.

According to the cylindrical type microwave discharge lamp, since the pattern of the light source is cylindrical, so that distribution of the light at the second focal point may be made cylindrical, the temperature gradient may be gradual or acute by rotating the lamp.

Since the pattern of light emission the cylindrical type microwave discharge lamp is cylindrical, the temperature gradient of the test sample may be set to be acute or gradual, so that the heating zone suitable for the relevant crystal growth may be selected. Furthermore, since the light emsission spectrum can be widely selected from the ultraviolet zone to the infrared zone, a wide range of test samples may be heated. In particular, since glass may be melted by image heating, the present invention is particularly effective in production of pure glass for space application which exceedingly enhances the efficiency of fiber cable.

By rotating the cylindrical type microwave discharge lamp to change its orientation, the temperature gradient at the test sample may be made acute or gradual.

When the light source is of a disc-like configuration, the distribution of the light at the second focal point can accocrdingly be made of a disc-like configuration, and uniform heating may be provided along the entire periphery of the test sample, thus eliminating the necessity of rotating the test sample at a high rotational speed. Furthermore, if the lamp is rotated by 90 degrees, the test sample can be heated in a wide range. Still furhter, since the light emission wavelength of the lamp can be set at the zones from the ultraviolet to the infrared zones, the image heating is made possible in the adsorption band of glass material.

Further, according to the present invention, since the pattern of light emission by the disc type plasma lamp is in a disc-like configuration, the temperature gradient at the test sample can be acute or gradual by rotating the disc type plasma lamp. Accordingly, the heating zone suitable for crystal growth may be selected, so that a high quality, devoid of cracks in the crystal, may be attained.

Further, since the light emission spectrum can be selected from the ultraviolet zone to the infrared zone, a wide range of the test samples can be heated. Particularly, since glass may be melted by image heating, pure infrared glass which exceedingly enhance the efficiency of fiber cable may be advantageously produced in space as well as on the earth.

Still further, since the test sample may be uniformly heated, it is not so necessary to rotate the test sample for uniform heat distribution. And since crystal growth is possible at a low rotation speed, it is possible to remove bubbles in the crystal especially at the microgravity. More specifically, the bubbles may be moved outwardly by convection due to the temperature gradient.

Furthermore, since the emission wavelength of the lamp can be selected from the ultraviolet zone to the infrared zone, image heating can be effected within an absorption band of a laser glass or the like. It is possible, therefore, to form an interface of a solid solution layer into a recess shape and hence to enlarge the formed crystal in size (because the center portion of the crystal is subject to a higher temperature while the side portion thereof is subject to a lower temperature).

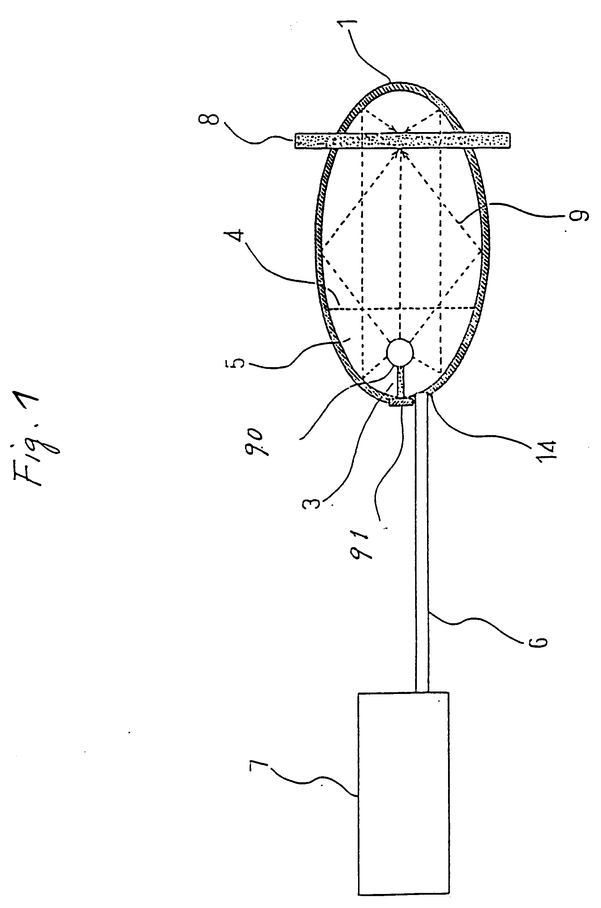

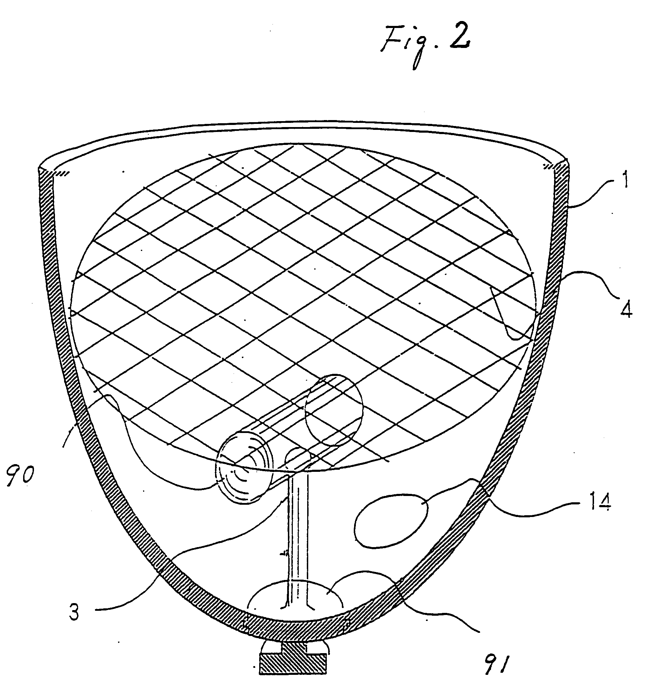

Figs. 1 and 2 schematically illustrate the constitution of the image heating apparatus using a single elliptical ball microwave discharge particularly utilizing a rotatable cylindrical type microwave discharge plasma lamp according to the first embodiment of the present invention;
   and

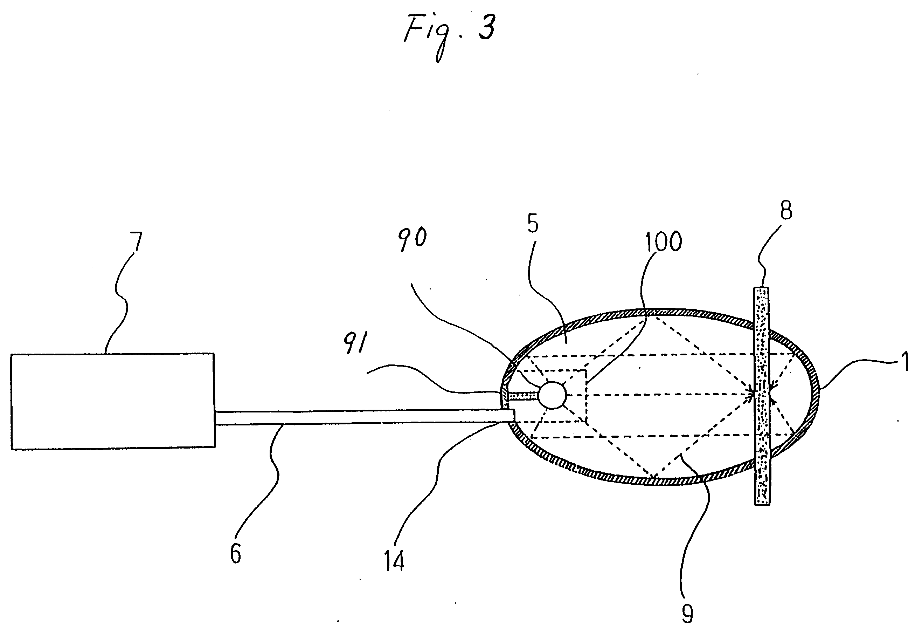

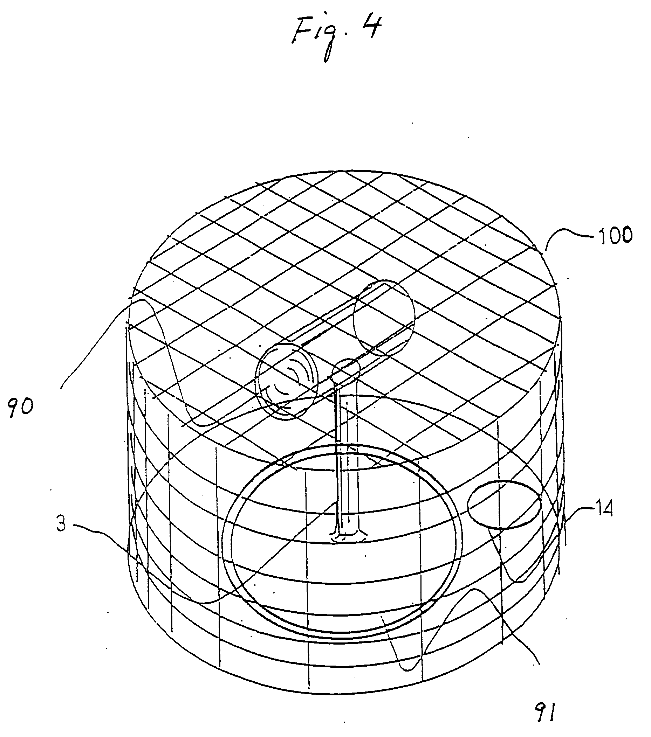

Figs. 3 and 4 schematically illustrate the constitution of the image heating apparatus using a single elliptical ball microwave discharge particularly utilizing a rotatable cylindrical type microwave discharge plasma lamp in the electric wave shielding plate of a cup-like configuration according to the second embodiment of the present invention.

In Figs. 1 and 2, numeral 90, is a cylindrical type plasma lamp which encloses such an element as potassium or the like inside the container of a cylinder-like hollow member made of glass or a translucent ceramic material, generates plasma by heating the element and emits the light 9. Numeral 91 designates a rotary fastener adapted to rotate at the end of the elliptical mirror 1 with the support tool 3 fixed thereto and made of an electric wave transmissive material. In these drawings, microwave power having a high frequency of 2 GHz or the like and a few kW is applied to the cavity resonator 5 defined by the end portion of the elliptical mirror 1 and the electric wave shielding plate 4 from the high frequency wave oscillator 7 via the wave guide 6 and the window 14. The plasma lamp 90 of a cylindrical type incorporated in the cavity resonator 5 is capable of generating plasma and emitting an intense light. This light is reflected at the inner surface of the elliptical mirror 1 and cylindrically condensed at the test sample at the second focal point. The test sample 8 is here heated and melted.When the test sample is pulled upwardly while it is slowly rotated, crystal growth will proceed.

Figs. 3 and 4 illustrate the second embodiment of the present invention. It is to be noted that those components are the same as those in the first embodiment are denoted with same numerals. In these drawings, numeral 100 designates an electic wave shielding container of a cup-like configuration which defines the cavity resonator 5 with the peripheral portion at the open side of the electric wave shielding container of a cup-like configuration being in contact with the elliptical mirror 1 at the first focal point and disposes the cylindrical type plasma lamp 90 in the cup-like cavity resonator 5.

Since the emission spectrum of the cylindrical type plasma lamp 90 can be concentrated at the near infra-red zone or the ultraviolet zone which provides a wavelength having the highest absorptivity of the test sample 8, a very high heating efficiency can be attained compared to that of a xenon lamp, a halogen lamp or the like. Also, since the wavelength of the light emission can be selectively changed from the ultraviolet zone to the infrared zone by selecting a sort of the elements which is filled in the microwave discharge lamp, heating can be executed by use of wavelength having combined optical characteristics of glass, metal, semiconductor and the like (in order words, various sorts of microwave discharge lamps are provided with different elements such as ultraviolet light being provided by mercury, near infrared light by potassium and so forth).

As explained in connection with the first embodiment shown in Figs. 1 and 2 and the second embodiment shown in Figs. 3 and 4, the cylindrical type microwave discharge lamp 90 can be rotated by the rotary fastener 91, and hence the heated zone of the sample 8 can be reduced.

As explained above, the respective embodiments of the present invention include each one of the rotary elliptical mirror. By employing a second rotary elliptical mirror identical in constitution and so mounted along the longitudinal axis to share the same second focal point, and installing a second prisma lamp at the end of the second rotary elliptical mirror, the entire surface of a test sample may be uniformly irradiated by the light emitted by both plasma lamps.

## Claims

1. An image heating apparatus using a plasma lamp comprising:
at least one rotary elliptical mirror means having a reflection surface of a rotary elliptical body at the inside;
plasma lamp means disposed at a first focal point of said rotary elliptical mirror means;
means for supporting said plasma lamp means;
electric wave shielding means provided inside said rotary elliptical mirror means;
cavity resonator means defined by said rotary elliptical mirror means and said electric wave shielding means, and adapted to accommodate said plasma lamp means;
high frequency oscillator means adapted to supply electromagnetic wave to said cavity resonator means via a wave guide; and
a test sample disposed at a second focal point of said rotary elliptical mirror means,
**characterized in that**
said plasma lamp means is rotatable at the end of said elliptical mirror.

2. An image heating apparatus according to claim 1,
**characterized in that**
said plasma lamp means is a cylindrical type microwave discharge plasma lamp.

3. An image heating apparatus according to claim 1,
**characterized in that**
said plasma lamp means is a disc type microwave discharge plasma lamp.

## Patentansprüche

1. Vorrichtung zum Aufheizen mittels eines Bildes unter Verwendung einer Plasmalampe mit mindestens einer drehbaren elliptischen Spiegelanordnung mit einer Reflexionsoberfläche eines drehbaren elliptischen Körpers im Inneren, einer Plasmalampeneinrichtung, die an einem ersten Brennpunkt der drehbaren elliptischen Spiegelanordnung angeordnet ist,
Mitteln zum Abstützen der Plasmalampeneinrichtung, einer Abschirmeinrichtung für elektrische Wellen, die innerhalb der drehbaren elliptischen Spiegelanordnung vorgesehen ist,
einer Hohlraumresonatoreinrichtung, die durch die drehbare elliptische Spiegelanordnung und die Abschirmeinrichtung für elektrische Wellen begrenzt ist und die Plasmalampeneinrichtung aufnimmt,
einer Hochfrequenz-Oszillatoreinrichtung, die über einen Wellenleiter elektromagnetische Wellen zu der Hohlraumresonatoreinrichtung liefert, und einem Prüfling, der an dem zweiten Brennpunkt der drehbaren elliptischen Spiegelanordnung angeordnet ist,
**dadurch gekennzeichnet,**
daß die Plasmalampeneinrichtung drehbar am Ende des elliptischen Spiegels angeordnet ist.

2. Vorrichtung nach Anspruch 1, dadurch gekennzeichnet, daß die Plasmalampeneinrichtung eine zylindrische Mikrowellen-Plasmaentladungslampe ist.

3. Vorrichtung nach Anspruch 1, dadurch gekennzeichnet, daß die Plasmalampenanordnung eine scheibenförmige Mikrowellen-Plasmaentladungslampe ist.

## Revendications

1. Appareil de chauffage d'image utilisant une lampe à plasma comprenant:
au moins un moyen faisant miroir elliptique Tournant disposant d'une surface réfléchissante à l'intérieur d'un corps elliptique tournant;
un moyen faisant lampe à plasma disposé sur un premier point focal dudit moyen faisant miroir elliptique tournant;
un moyen destiné à supporter le moyen faisant lampe à plasma;
un moyen faisant écran aux ondes électriques prévu à l'intérieur du moyen faisant miroir elliptique tournant;
un moyen faisant cavité résonnante défini par ledit moyen faisant miroir elliptique tournant;
et un moyen faisant écran aux ondes électriques, et adapté de façon à contenir ledit moyen faisant lampe à plasma;
un moyen oscillateur à haute fréquence adapté pour délivrer une onde électro-magnétique audit moyen faisant cavité résonnante par l'intermédiaire d'un guide d'onde; et
un échantillon pour essai disposé sur un second point focal dudit moyen faisant miroir elliptique tournant, caractérisé en ce que,
le moyen faisant lampe à plasma est rotatif au niveau de l'extrémité dudit miroir elliptique.

2. Appareil de chauffage d'image selon la revendication 1, caractérisé en ce que
ledit moyen faisant lampe à plasma est une lampe à plasma à décharge par micro-ondes du type cylindrique.

3. Appareil de chauffage d'image selon la revendication 1, caractérisé en ce que ledit moyen faisant lampe à plasma est une lampe à plasma à décharge par micro-ondes du type à disque.
